**Europäisches Patentamt**

**European Patent Office**

**Office européen des brevets**

(19)

(11) Veröffentlichungsnummer : **0 014 435**
**B1**

# EUROPÄISCHE PATENTSCHRIFT

(12)

(45) Veröffentlichungstag der Patentschrift :
**16.02.83**

(21) Anmeldenummer : **80100474.8**

(22) Anmeldetag : **30.01.80**

(51) Int. Cl.³ : **H 01 L 29/74**

(54) **Thyristor mit Steuerung durch Feldeffekttransistor.**

(30) Priorität : **06.02.79 DE 2904424**

(43) Veröffentlichungstag der Anmeldung :
**20.08.80 Patentblatt 80/17**

(45) Bekanntmachung des Hinweises auf die Patenterteilung : **16.02.83 Patentblatt 83/07**

(84) Benannte Vertragsstaaten :
**CH FR GB IT**

(56) Entgegenhaltungen :
**Keine**

(73) Patentinhaber : **SIEMENS AKTIENGESELLSCHAFT**
**Berlin und München Wittelsbacherplatz 2**
**D-8000 München 2 (DE)**

(72) Erfinder : **Krausse, Jürgen, Dr. Ing.**
**Weidenstrasse 12**
**D-8011 Baldham (DE)**
Erfinder : **Tihanyi, Jenö, Dr. Ing. Dipl. Phys.**
**Wolfratshauser Strasse 179 b**
**D-8000 München 71 (DE)**

Thyristor mit Steuerung durch Feldeffekttransistor

Die vorliegende Erfindung bezieht sich auf einen Thyristor mit einem Halbleiterkörper, bei dem eine äußere katodenseitige Zone, eine innere Zone, eine Mittelzone und eine anodenseitige Zone aneinandergrenzend, übereinander angeordnet sind und die äußere katodenseitige Zone und die anodenseitige Zone mit einer Katodenelektrode bzw. einer Anodenelektrode kontaktiert sind und an dessen einer Seite im selben Halbleiterkörper ein Feldeffekttransistor angeordnet ist, dessen Zonen aus Teilen der Zonen des Thyristors bestehen.

Ein solcher Thyristor ist beispielsweise in der FR-A-2 110 299 beschrieben worden. Bei diesem Thyristor wird der Kanal des Feldeffekttransistors (FET) durch eine der beiden Mittelzonen gebildet. Dies bedingt eine große Kanallänge für den Fall, daß der Thyristor für hohe Sperrspannungen geeignet sein soll. Eine kleine Kanallänge läßt sich nur erreichen, wenn die genannte Innenzone dünn gemacht wird. Damit ist jedoch die maximale Sperrspannung des Thyristors auf niedrige Werte begrenzt.

Der Erfindung liegt die Aufgabe zugrunde, einen Thyristor der eingangs erwähnten Art so weiterzubilden, daß eine hohe Sperrspannung bei geringer Kanallänge erzielbar ist.

Die Erfindung ist dadurch gekennzeichnet, daß die Mittelzone des Thyristors im Vergleich zu den anderen Zonen schwach dotiert ist, daß der Thyristor einen Nebenschluß zwischen der äußeren katodenseitigen Zone und der angrenzenden inneren Zone aufweist, daß der Feldeffekttransistor an der dem Nebenschluß abgewandten Seite der äußeren katodenseitigen Zone angeordnet ist, daß die Sourcezone des Feldeffekttransistors aus einem Teil der äußeren katodenseitigen Zone und die Drainzone aus einem an die Oberfläche des Halbleiterkörpers tretenden Teil der Mittelzone besteht, daß die Steuerzone durch ein zwischen den genannten Zonen an die Oberfläche tretendes Teil der angrenzenden inneren Zone gebildet ist und mindestens dieses Teil der inneren Zone von einer gegen die Oberfläche des Halbleiterkörpers isolierten Steuerelektrode bedeckt ist.

Aus der DE-C-1 156 510 ist zwar bereits ein Thyristor mit einem Nebenschluß zwischen äußerer und innerer katodenseitiger Zone beschrieben worden. Hierbei handelt es sich jedoch um einen durch Trägerinjektion und nicht um einen durch Feldeffekt steuerbaren Thyristor.

Weiterbildungen der Erfindung sind Gegenstand der Unteransprüche.

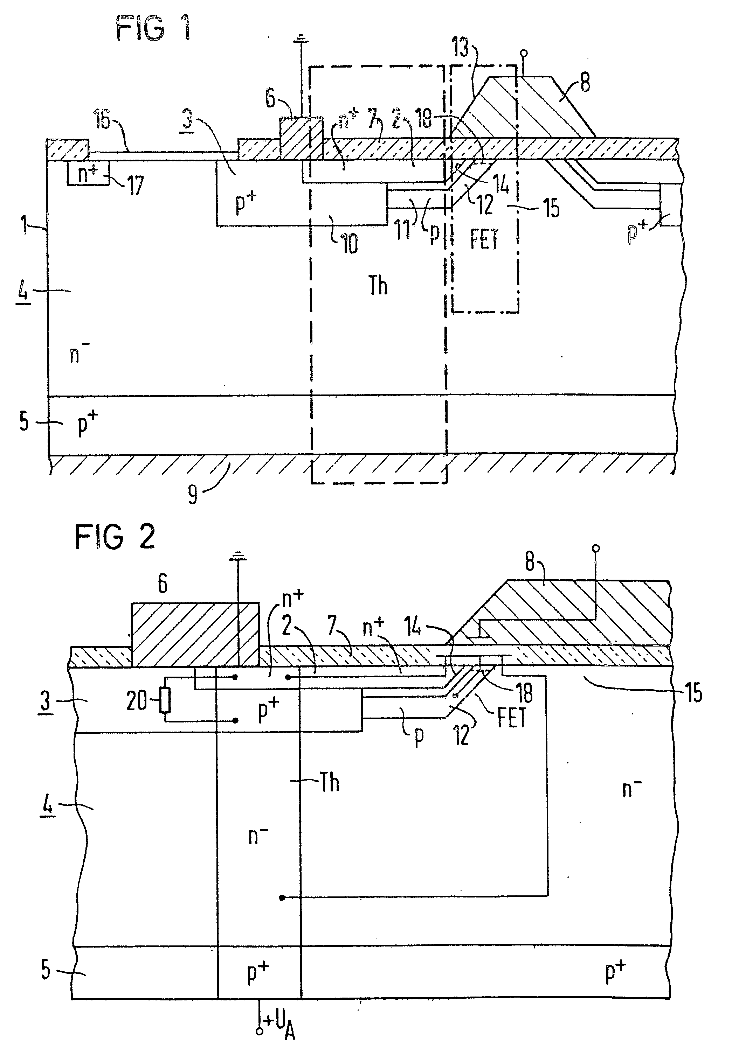

Die Erfindung wird an Hand eines Ausführungsbeispiels in Verbindung mit den Fig. 1 und 2 näher erläutert. Es zeigen :

Figur 1 einen Schnitt durch den Halbleiterkörper des erfindungsgemäßen Thyristors und

Figur 2 das in den Halbleiterkörper des Thyristors nach Fig. 1 eingezeichnete Ersatzschaltbild.

In Fig. 1 ist der Halbleiterkörper des Thyristors mit 1 bezeichnet. Er weist eine katodenseitige äußere Zone 2, eine daran angrenzende innere Zone 3, eine Mittelzone 4 und eine anodenseitige äußere Zone 5 auf. Die genannten Zonen haben abwechselnden Leitungstyp, zum Beispiel die Zonenfolge npnp. Die Mittelzone 4 ist, wie bei Thyristoren üblich, gegenüber den Zonen 2, 3 und 5 schwach dotiert. Sie kann über ihre Dicke konstant dotiert sein. Die Zone 2 und 3 sind durch einen Katodenkontakt 6 kontaktiert, der zur Stromzuführung dient und gleichzeitig den zum Betrieb eines Thyristors notwendigen Emitter-Basis-Nebenschluß herstellt. Anodenseitig ist der Halbleiterkörper mit einer Anodenelektrode 9 kontaktiert, die zum Beispiel Teil eines Gehäuses sein kann. Die Zonen 2, 3, 4, 5 und die Elektroden 6, 9 gehören zum eigentlichen Thyristor, das heißt zum Leistung schaltenden Bauelement. Dieser Thyristor ist gestrichelt umrahmt und mit Th bezeichnet.

Die Oberfläche der Zonen 2, 3 ist zum größten Teil mit einer Isolierschicht 7 bedeckt, die zum Beispiel aus Siliciumdioxid besteht. Auf der Isolierschicht 7 ist eine Steuerelektrode 8 angeordnet, die damit gegen die Oberfläche des Halbleiterkörpers isoliert ist. Die Zone 3 weist ein Teil 12 auf, das unter der Steuerelektrode 8 an die Oberfläche des Halbleiterkörpers 1 tritt. Die Mittelzone 4 hat ein Teil 15, das ebenfalls an die Oberfläche des Halbleiterkörpers 1 tritt. Das Teil 12 der inneren Zone 3 liegt dabei zwischen der katodenseitigen äußeren Zone 2 und dem Teil 15 der Mittelzone 4. Die Zone 2 bildet die Quelle und das Teil 15 der Zone 4 die Senke des eingangs erwähnten Feldeffekttransistors. Das Teil 12 ist die Steuerzone. Im Teil 12 bildet sich an der Oberfläche in Abhängigkeit von der an die Steuerelektrode 8 angelegten Spannung durch Ladungsträgerinversion ein Kanal 18 aus. Dieser ermöglicht bei angelegter Steuerspannung einen Stromfluß von der katodenseitigen äußeren Zone 2 über den Kanal 18 zur Mittelzone 4. Der Feldeffekttransistor ist durch gestrichelte Linien umrandet und mit FET bezeichnet.

Die Steuerelektrode 8 kann aus stark dotiertem polykristallinem Silicium mit zum Rand schräg abfallenden Flanken 13 bestehen. Dies ist dann von Vorteil, wenn die Zone 2 und die Teile 11, 12 der Zone 3 durch doppelte Ionenimplantation erzeugt werden. Für die zu implantierenden Ionen wirkt die Steuerelektrode 8 als Maske derart, daß der Innenrand der Zone 2 eine zur Oberfläche des Halbleiterkörpers ansteigende schräge Flanke 14 erhält, während das oben erwähnte Teil 12 der Zone 3 unter dem gleichen Winkel schräg zur Oberfläche des Halbleiterkörpers ansteigt. Mit der Ionenimplantation kann man kleine Schichtdicken sehr genau herstellen. Mit einer kleinen Dicke des Teils 12 erhält man eine kurze Länge des Kanals 18 und damit hohe Schaltgeschwindigkeit. Das Teil 10 der Zone 3 kann durch Diffusion oder eine Ionenimplantation unter anderen Bedingungen erzeugt werden. Damit lassen sich die Eigenschaften des Thyristors Th unabhängig von denen des Feldeffekttransistors FET einstellen. Insbesonders ist es empfehlenswert, das Teil 12 der Innenzone 3 schwächer als ihr Teil 10 zu dotieren, um die Feldstärke in der Steuerzone an der Halbleiteroberfläche klein zu halten.

Zur Herabsetzung der Oberflächenfeldstärke zwischen den Zonen 3 und 4 können Schutzzonen 17 vorgesehen sein, die gegenüber der Zone 4 stark dotiert sind. Im übrigen kann die Oberfläche des Halbleiterkörpers außerhalb der Isolierschicht 7 mit einer dünnen Passivierungsschicht 16 bedeckt sein, die beispielsweise aus aufgedampftem Silicium besteht. Diese Passivierungsschicht wird dann mit Siliciumdioxid bedeckt.

Die in Fig. 1 gezeigte Struktur kann in der Aufsicht rechteckig und symmetrisch zu einer durch die Steuerelektrode gelegten Ebene aufgebaut sein. Für höhere Leistungen empfiehlt sich eine aus einer Vielzahl dieser Strukturen gebildete Anordnung, die rasterförmig auf einem großen Chip angeordnet sind. Die Steuerelektroden und Katodenelektroden werden dann wie bei integrierten Schaltkreisen üblich durch Leiterbahnen miteinander verbunden.

Der beschriebene Thyristor kann wie folgt dimensioniert sein : Dicke der Zone 5 ca. 200 μm ; Dicke der Mittelzone 4 : 5 bis 50 μm, Dotierung $5 \cdot 10^{13}$ bis $5 \cdot 10^{15}$ cm$^{-3}$ ; Dicke des Teils 10 : 1 bis 10 μm, Randdotierung $10^{17}$ bis $10^{18}$ cm$^{-3}$ ; Dicke der Teile 11, 12 ca. 0,5 μm, Bor-Implantation Dosis 1 bis $4 \cdot 10^{12}$ cm$^{-2}$, Energie 100 bis 800 keV ; Dicke der Isolierschicht 7 : 0,03 bis 0,2 μm ; Dicke der Zone 2 ca. 0,1 μm, Arsen-Implantation Dosis $10^{13}$ bis $10^{16}$ cm$^{-2}$, Energie 50 bis 200 keV ; Dicke der Steuerelektrode 0,4 bis 1 μ ; Kanallänge ca. 0,5 μm.

Zur Erläuterung der Wirkungsweise der Erfindung wird auf die Fig. 2 verwiesen. Gleiche Teile sind hier mit gleichen Bezugszeichen wie in Fig. 1 versehen. Der Emitter-Basis-Widerstand des Thyristors ist mit 20 bezeichnet. Es ist ersichtlich, daß an der Oberfläche des Teils 12 (Steuerzone) der Zone 3 durch Ladungsträgerinversion ein Kanal 18 gebildet wird, wenn an die Steuerelektrode 8 positives Potential gelegt wird. Bei Überschreiten der Einsatzspannung fließt bei der eingezeichneten Polarität ein Strom durch den Feldeffekttransistor, das heißt von der Katodenelektrode 6 über die Zone 2, den Kanal 8 in die Mittelzone 4. Aus Gründen des Ladungsträgergleichgewichts am pn-Übergang zwischen den Zonen 4 und 5 werden nun positive Ladungsträger in die Mittelzone 4 injiziert. Diese fließen zur Zone 3 und verursachen dort eine Emission von Elektronen aus der Zone 2. Bei Erreichen der Zündbedingung wird der Thyristor Th gezündet. Die Steuerung des Thyristors erfolgt damit abgesehen von den dielektrischen Verlusten in der Isolierschicht 7 leistungslos.

**Ansprüche**

1. Thyristor (Th) mit einem Halbleiterkörper (1), bei dem eine äußere katodenseitige Zone (2), eine innere Zone (3), eine Mittelzone (4) und eine anodenseitige Zone (5) aneinandergrenzend, übereinander angeordnet sind und die äußere katodenseitige Zone (2) und die anodenseitige Zone (5) mit einer Katodenelektrode (6) bzw. einer Anodenelektrode (9) kontaktiert sind und an dessen einer Seite im selben Halbleiterkörper (1) ein Feldeffekttransistor (FET) angeordnet ist, dessen Zonen aus Teilen (12, 14, 15) der Zonen des Thyristors bestehen, dadurch gekennzeichnet, daß die Mittelzone (4) des Thyristors im Vergleich zu den anderen Zonen schwach dotiert ist, daß der Thyristor (Th) einen Nebenschluß zwischen der äußeren katodenseitigen Zone (2) und der angrenzenden inneren Zone (3) aufweist, daß der Feldeffekttransistor (FET) an der dem Nebenschluß abgewandten Seite der äußeren katodenseitigen Zone (2) angeordnet ist, daß die Sourcezone des Feldeffekttransistors aus einem Teil der äußeren katodenseitigen Zone (2) und die Drainzone aus einem an die Oberfläche des Halbleiterkörpers (1) tretenden Teil (15) der Mittelzone (4) besteht, daß die Steuerzone durch ein zwischen den genannten Zonen an die Oberfläche tretendes Teil (12) der angrenzenden inneren Zone (3) gebildet ist und mindestens dieses Teil (12) der inneren Zone (3) von einer gegen die Oberfläche des Halbleiterkörpers isolierten Steuerelektrode (8) bedeckt ist.

2. Thyristor nach Anspruch 1, dadurch gekennzeichnet, daß mindestens die zum Feldeffekttransistor (FET) gehörenden Teile der äußeren katodenseitigen Zone (2) und der angrenzenden inneren Zone (3) durch Ionenimplantation hergestellt sind.

3. Thyristor nach Anspruch 1 oder 2, dadurch gekennzeichnet, daß das an die Oberfläche tretende Teil (12) der angrenzenden inneren Zone (3) dünner als ihr unter der äußeren katodenseitigen Zone (2) liegende Teil (10) ist.

4. Thyristor nach einem der Ansprüche 1 bis 3, dadurch gekennzeichnet, daß die Steuerelektrode (8) aus hochdotiertem polykristallinem Silicium besteht und zu ihrem Rand hin abgeschrägte Flanken (13) hat.

5. Thyristor nach Anspruch 3 oder 4, dadurch gekennzeichnet, daß die äußere katodenseitige Zone (2) bis unter die Steuerelektrode (8) reicht, daß ihr unter der Steuerelektrode (8) liegende Rand (14) zur Oberfläche des Halbleiterkörpers (1) hin abgeschrägt ist, und daß das unter der Steuerelektrode liegende Teil (12) der angrenzenden Innenzone (3) schräg zur Oberfläche ansteigend angeordnet ist.

6. Thyristor nach einem der Ansprüche 1 bis 5, dadurch gekennzeichnet, daß das zum Feldeffekttransistor (FET) gehörende Teil (12) der angrenzenden Innenzone (3) dünner als das zum Thyristor (Th) gehörende Teil (10) dieser Innenzone ist.

7. Thyristor nach einem der Ansprüche 1 bis 6, dadurch gekennzeichnet, daß das zum Feldeffekttransistor (FET) gehörende Teil (12) der angrenzenden Innenzone (3) schwächer dotiert ist als das zum Thyristor (Th) gehörende Teil (10) dieser Innenzone:

## Claims

1. A thyristor (Th) comprising a semiconductor body (1), in which an outer cathode-side zone (2), an inner zone (3), a central zone (4) and an anodeside zone (5) are arranged in contact one upon another, and the outer cathode-side zone (2) and the anode-side zone (5) are respectively contacted by a cathode electrode (6) and an anode electrode (9), and on one side of which, in the same semiconductor body (1), there is arranged a field effect transistor (FET), whose zones consist of parts (12, 14, 15) of the zones of the thyristor, characterised in that the centre zone (4) of the thyristor is weakly doped in comparison with the other zones ; that the thyristor (Th) has a shunt between the outer cathode-side zone (2) and the adjoining inner zone (3) ; that the field effect transistor (FET) is arranged on the side of the outer cathode-side zone (2) which faces away from the shunt ; that the source zone of the field effect transistor consists of a part of the outer cathode-side zone (2) and the drain zone consists of a part (15) of the central zone (4) which reaches the surface of the semiconductor body (1) ; that the control zone is formed by a part (12) of the adjoining inner zone (3) which comes to the surface between said zones, and at least this part (12) of the inner zone (3) is covered by a control electrode (8) which is insulated from the surface of the semiconductor body.

2. A thyristor as claimed in Claim 1, characterised in that at least the parts assigned to the field effect transistor (FET), of the outer cathode-side zone (2) and of the adjoining inner zone (3) are produced by ion implantation.

3. A thyristor as claimed in Claim 1 or Claim 2, characterised in that the part (12) of the adjoining inner zone (3) which extends to the surface is thinner than the portion (10) of this zone which is located below the outer cathode-side zone (2).

4. A thyristor as claimed in one of Claims 1 to 3, characterised in that the control electrode (8) consists of highly doped polycrystalline silicon and has flanks (13) which are sloped towards its edge.

5. A thyristor as claimed in Claim 3 or Claim 4, characterised in that the outer cathode-side zone (2) extends to below the control electrode (8), that its edge (14) which is located below the control electrode (8) is sloped towards the surface of the semiconductor body (1), and that the part (12) of the adjoining inner zone (3), which is located below the control electrode, is obliquely arranged so as to rise to the surface.

6. A thyristor as claimed in one of Claims 1 to 5, characterised in that the part (12) of the adjoining inner zone (3) which is assigned to the field effect transistor (FET), is thinner than the part (10) of this inner zone which is assigned to the thyristor (Th).

7. A thyristor as claimed in one of Claims 1 to 6, characterised in that the part (12) of the adjoining inner zone (3) which is assigned to the field effect transistor (FET), is more weakly doped than the part (10) of this inner zone which is assigned to the thyristor (Th).

## Revendications

1. Thyristor (Th) comportant un corps semiconducteur (1), dans lequel sont disposées les unes au-dessus des autres et de façon contiguë une zone extérieure (2) côté cathode, une zone intérieure (3), une zone centrale (4) et une zone (5) côté anode, et la zone extérieure (2) côté cathode et la zone (5) côté anode sont respectivement contactées avec une électrode de cathode (6) et une électrode d'anode (9), et sur un côté duquel dans le même corps semiconducteur (1), est disposé un transistor à effet de champ (TEC) dont les zones sont constituées par des parties (12, 14, 15) des zones du thyristor, caractérisé en ce que la zone centrale (4) du thyristor est faiblement dopée par rapport aux autres zones, que le thyristor (Th) comporte une dérivation entre la zone extérieure (2) côté cathode et la zone intérieure (3) contiguë, que le transistor à effet de champ (TEC) est disposé du côté de la zone extérieure (2) côté cathode qui est opposé à la dérivation, que la zone de source du transistor à effet de champ est constituée par une partie de la zone extérieure (2) côté cathode et la zone de drain est constituée par une partie (15) de la zone centrale (4) apparaissant sur la surface du corps semiconducteur (1), que la zone de porte est formée par une partie (12) de la zone intérieure contiguë (3) apparaissant à la surface entre lesdites zones et qu'au moins cette partie (12) de la zone intérieure (3) est recouverte par une électrode de porte (8) isolée vis-à-vis de la surface du corps semiconducteur.

2. Thyristor suivant la revendication 1, caractérisé en ce qu'au moins les parties de la zone (2) côté cathode appartenant au transistor à effet de champ (TEC) et la zone intérieure contiguë (3) sont réalisées par implantation d'ions.

3. Thyristor suivant l'une des revendications 1 ou 2, caractérisé en ce que la partie (12) apparaissant à la surface de la zone intérieure contiguë (3) est plus mince que sa partie (10) se trouvant sous la zone extérieure (2) côté cathode.

4. Thyristor suivant l'une des revendications 1 à 3, caractérisé en ce que l'électrode de porte (8) est constituée par du silicium polycristallin fortement dopé et comporte des flancs (13) descendant obliquement en direction du bord.

5. Thyristor suivant l'une des revendications 3 ou 4, caractérisé en ce que la zone extérieure (2) côté cathode arrive jusque sous l'électrode de porte (8), que son bord (14) se trouvant sous l'électrode de porte (8) descend obliquement en direction de la surface du corps semiconducteur (1), et que la partie (12) de la zone intérieure contiguë (3) qui se trouve sous l'électrode de porte remonte obliquement en direction de la surface.

6. Thyristor suivant l'une des revendications 1 à 5, caractérisé en ce que la partie (12) de la zone intérieure contiguë (3) qui appartient au transistor à effet de champ (TEC) est plus mince que la partie (10) de cette zone intérieure qui appartient au thyristor (Th).

7. Thyristor suivant l'une des revendications 1 à 6, caractérisé en ce que la partie (12) de la zone intérieure contiguë (3) qui appartient au transistor à effet de champ (TEC) est plus faiblement dopée que la partie (10) de cette zone intérieure qui appartient au thyristor (Th).

FIG 1

FIG 2